# EUROPEAN PATENT SPECIFICATION

(11) **EP 3 254 199 B1**
(45) Date of publication and mention of the grant of the patent: **30.12.2020**
(21) Application number: 16707579.5
(22) Date of filing: 03.02.2016
(51) Int. Cl.: G06F 11/36

(54) **SYSTEM AND METHOD FOR GENERATING CROSS-CORE BREAKPOINTS IN A MULTI-CORE MICROCONTROLLER**
SYSTEM UND VERFAHREN ZUR ERZEUGUNG VON CROSSCORE-BREAKPOINTS IN EINEM MEHRKERN-MIKROSTEUERGERÄT
SYSTÈME ET PROCÉDÉ POUR GÉNÉRER DES POINTS D'INTERRUPTION INTER-COEUR DANS UN MICROCONTRÔLEUR MULTI-COEUR

(30) Priority: 05.02.2015 US 201562112552 P; 01.02.2016 US 201615012287
(43) Date of publication of application: 13.12.2017
(73) Proprietor: Microchip Technology Incorporated, Chandler, AZ 85224-6199 (US)
(72) Inventor: KRIS, Bryan, Gilbert, Arizona 85298 (US); CATHERWOOD, Mike, Georgetown, Texas 78633 (US); MICKEY, Dave, Chandler, Arizona 85249 (US); FALL, Brian, Mesa, Arizona 85215 (US); WILKIE, Calum, Chandler, Arizona 85224 (US); SHEARD, Vincent, Tempe, Arizona 85284 (US); DUMAIS, Alex, Gilbert, Arizona 95297 (US)
(74) Representative: sgb europe
(86) International application number: PCT/US2016/016293
(87) International publication number: WO 2016/126774

(56) References cited:
- US-A1- 2003 014 736
- US-A1- 2007 180 322
- US-A1- 2013 111 270

## Description

The present disclosure relates to processors and, in particular, to systems and methods for generating cross-core breakpoints in a multi-core processor, in particular an asymmetric multi-core processor.

A processor breakpoint is a stopping place in a program, also known as a pause, put in place for debugging purposes. The processor breakpoint is typically triggered when a specific memory location is accessed. During the interruption, the memory, register, etc., environment is examined to determine whether the program is functioning as expected. The memory location can be in program memory and may comprise a specific instruction which when fetched by the processor may trigger the breakpoint and stop execution. These type of breakpoints may only need to compare the program counter with the respective memory address. However, the memory location may also be in data memory and either a write or read operation or both may trigger the breakpoint and stops further execution of instructions.

Most multi-processor devices use symmetrical processor cores. By definition, the cores are interchangeable, sharing memory, peripherals, and software tasks. The system software is allocated an available processor as it becomes free. Thus, a debugging is confined to a particular core. Accordingly, there is no need to determine what another core is doing at the same time.

In multi-processor devices with asymmetrical processor cores, however, the asymmetrical cores have differing memory and peripheral sets, may also operate at different speeds, and execute different software programs. In this case, a function of one processor can thereby affect another.

US Patent Application Publication US 2013/0111270 discloses an information system and control method of the same using a multi-core processor with shared program memory.

There is therefore a need to correlate a specific processor's breakpoint event with what the other processors are doing.

As will be explained in greater detail below, embodiments provide for communicating processor breakpoints to other processor cores in a multi-core processing device. This and other objects can be achieved by a method and integrated circuit device as defined in the independent claims. Further enhancements are characterized in the dependent claims. Embodiments may be particularly well-suited for use in a multi-core processing device.

According to an embodiment, a debugging method for an integrated circuit device comprising multiple processing cores, may comprise: activating a debugging breakpoint at a first processor core in the integrated circuit device, wherein the debugging breakpoint stops execution of instructions in the first processor core; and communicating the debugging breakpoint to a second processor core in the integrated circuit device.

According to a further embodiment, the method may further comprise setting one or more cross breakpoint enable bits in a break point register thereby enabling the step of communicating the debugging breakpoint. According to a further embodiment, communicating the debugging breakpoint may comprise asserting a breakpoint at the second processor core, wherein the breakpoint stops execution of instructions in the second processor core. According to a further embodiment, the method may further comprise setting one or more cross breakpoint interrupt enable bits in a break point register thereby enabling the step of communicating the debugging breakpoint. According to a further embodiment, communicating the debugging breakpoint may comprise asserting a breakpoint interrupt at an interrupt controller associated with the second processor core. According to a further embodiment, the second processor core may execute an interrupt service routine upon receiving said breakpoint interrupt. According to a further embodiment, the interrupt service routine may generate data related to the debugging breakpoint. According to a further embodiment, the data can be communicated to a host system. According to a further embodiment, the first processor core can be clocked by a first system clock and the second processor core is clocked by a second system clock which is different than the first system clock. According to a further embodiment, communicating the debugging breakpoint may comprise synchronizing the debugging breakpoint to the second system clock. According to a further embodiment, the debugging breakpoint can be generated from a plurality of programmable breakpoints. According to a further embodiment, said programmable breakpoints may comprise instruction breakpoints and data breakpoints. According to a further embodiment, the first processor core can be a master core and the second processor core can be a slave core. According to a further embodiment, the first processor core can be a slave core and the second processor core is a master core.

According to another embodiment, an integrated circuit device with a plurality of processor cores, comprising: a first processor core including first emulator logic for activating a first processor core breakpoint; a second processor core communicatively coupled to the first processor core and including second emulator logic; and a first cross breakpoint logic within the first emulator logic configured to communicate a breakpoint activated by the first emulator logic at the first processor core to the second processor core.

According to a further embodiment, the first cross breakpoint logic may communicate the breakpoint to the second emulator logic of the second processor core thereby stopping execution of instructions at the second processor core. According to a further embodiment, the integrated circuit device may further comprise a break point register comprising one or more cross breakpoint enable bits operable to enable the first cross breakpoint logic to communicate the breakpoint to the second emulator logic. According to a further embodiment, the second emulator logic may comprise a second cross breakpoint logic configured to communicate a breakpoint activated by the second emulator logic at the second processor core to the first processor core. According to a further embodiment, the cross breakpoint logic may communicate the breakpoint as an interrupt request to an interrupt input associated with the second processor core. According to a further embodiment, the integrated circuit device may further comprise a break point register comprising one or more cross breakpoint interrupt enable bits operable to enable the cross breakpoint logic to communicate the interrupt request to the interrupt input associated with the second processor core. According to a further embodiment, each emulator logic may comprise an interface coupled with a set of external pins. According to a further embodiment, a first set of peripheral devices can be integrated within the integrated circuit device and coupled with the first processor core thereby forming a first microcontroller and a second set of peripheral devices can be integrated within the integrated circuit device and coupled with the second processor core thereby forming a second microcontroller. According to a further embodiment, the first microcontroller can be operating as a master and the second microcontroller can be operating as a slave. According to a further embodiment, the first processor core can be clocked by a first system clock and the second processor core can be clocked by a second system clock which is different than the first system clock. According to a further embodiment, the integrated circuit device may further comprise clock crossing circuitry interfacing the cross breakpoint logic with the second processor core. According to a further embodiment, the clock crossing circuitry can be coupled between the cross breakpoint logic and an interrupt controller associated with the second processor core. According to a further embodiment, the first set of peripheral devices and/or the second set of peripheral devices may comprise a serial communication peripheral. According to a further embodiment, the first and/or second emulator logic can be operable to configure a plurality of programmable breakpoints. According to a further embodiment, said programmable breakpoints may comprise instruction breakpoints and data breakpoints.

The drawings accompanying and forming part of this specification are included to depict certain aspects of the disclosure. It should be noted that the features illustrated in the drawings are not necessarily drawn to scale. A more complete understanding of the disclosure and the advantages thereof may be acquired by referring to the following description, taken in conjunction with the accompanying drawings in which like reference numbers indicate like features and wherein:
FIG. 1 is a diagram illustrating an exemplary multicore processing device in accordance with embodiments.
FIG. 2 is a diagram illustrating an exemplary breakpoint register in accordance with embodiments.
FIG. 3 illustrates exemplary breakpoint control logic in accordance with embodiments.
FIG. 4 illustrates exemplary breakpoint interrupt control logic in accordance with embodiments.
FIG. 5 is a diagram illustrating an exemplary breakpoint status register in accordance with embodiments.
FIG. 6 illustrates an exemplary clock crossing circuit in accordance with embodiments.
FIG. 7 illustrates an exemplary system for debugging a multicore processing device in accordance with embodiments.
Fig. 8 illustrates an exemplary synchronizer pulse generator as used in the embodiment of Fig. 7.
Fig. 9 shows a development system with two emulators and a target board.
Fig. 10 shows a housing for an integrated circuit comprising a dual core microcontroller and its respective single function and multi-function pins.

The disclosure and various features and advantageous details thereof are explained more fully with reference to the exemplary embodiments illustrated in the accompanying drawings and detailed in the following description.

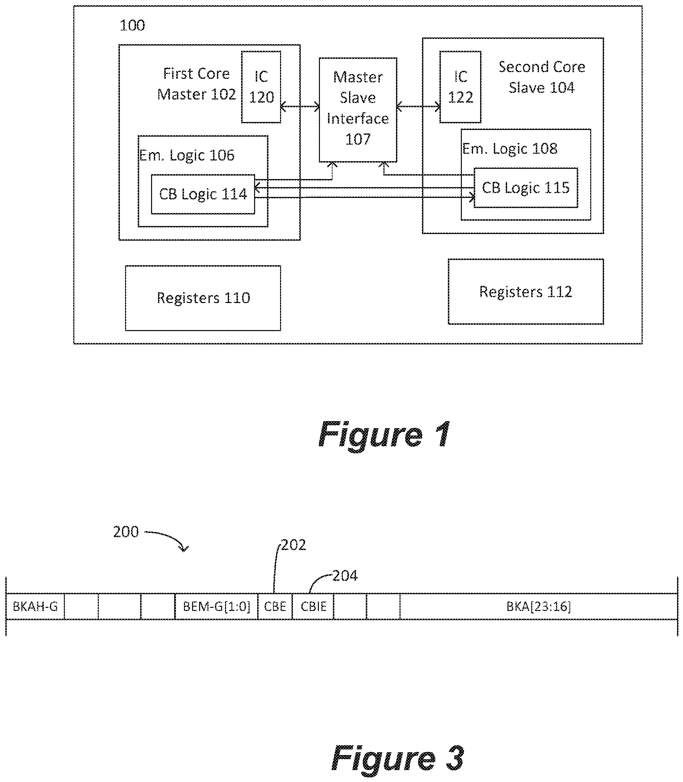

Turning now to the drawings and with particular attention to FIG. 1, a diagram illustrating an example asymmetric multicore processing device (i.c., microprocessor or microcontroller) in accordance with various embodiments is shown and generally identified by the reference numeral 100. In the context of the present application, the term "asymmetric" is used to describe that the two or more cores are operating independently. The processor cores may be identical but operate from different memories and in case of a microcontroller implementation with different peripheral devices. According to other embodiments, two different cores could be implemented or two identical cores that run with different system clocks may be implemented. However, the principles of the present application are not restricted to such implementations but may also be used in implementations with two identical cores that run with the same system clock but each core operates independent form the other core.

In the embodiment illustrated in Fig. 1, the processing device 100 may include a first core 102 and a second core 104. In some embodiments, the first core 102 may be, for example, a first microprocessor core (central processing unit) while the second core 104 may be a second microprocessor core or a DSP (digital signal processor). Other configurations of the two cores are possible. As will be explained in greater detail below, the first core 102 and the second core 104 may include or be communicatively coupled with emulator logic 106, 108 integrated within the cores, respectively. The emulator logic 106, 108 may further include cross break logic 114, 116, respectively, as will be explained in greater detail below. Each core 102 and 104 also comprises an interrupt controller 120 and 122, respectively. Finally, each core 102, 104 may be associated with a set of control and status registers 110, 112, respectively. Depending on the architecture of the cores, these registers may be either integrated within the cores or as shown in Fig. 1 arranged externally from the cores 102, 104. In particular, some embodiments provide status registers 110, 112 for propagating a breakpoint from one processor core to another as breakpoint requests and/or interrupt enable requests and for setting status bits indicating that a breakpoint has been received. In addition, in some embodiments, the processing device 100 may include a programmable interrupt controllers 120, 122 as mentioned above for asserting interrupts at each corresponding core. Furthermore, a master-Slave interface 107 is shown in Fig. 1 which provides for communication between the two cores 102 and 104. The shown configuration is exemplary only. Other configurations are possible. For example, some processing devices may employ more than two cores and associated control and status registry.

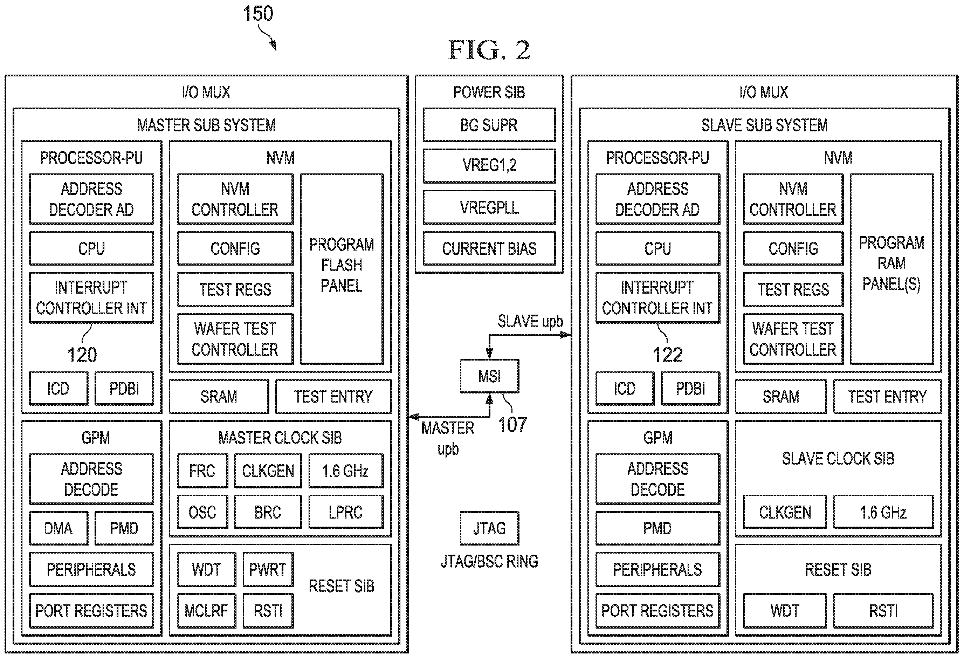

The two cores can be arranged in a Master/Slave Core configuration within an integrated circuit device 150 as shown in Fig. 2, for example, the first microprocessor core may be implemented as the master core whereas the second microprocessor or DSP core is implemented as the slave. Such a configuration allows the master to control certain functions The integrated circuit (IC) device with multiple cores may be further designed to implement two microcontrollers. According to some embodiments, as shown in Fig. 2, respective independent peripherals devices, such as DMA, PMD, as well as memory, I/O ports for each core are integrated within the IC to form two separate microcontrollers within a single IC device. The IC may further comprise configurable shared resources for master and slave device. For example, the master may be provided with 64-128 Kbytes of program flash memory with ECC and 16K RAM. According to one embodiment, the slave may be equipped with 24 Kbytes of program RAM (PRAM) with ECC which may be volatile and 4K data memory RAM. Other configurations are possible. Message Boxes and FIFO (MSI) may be used to communicate between the master and slave cores. Other hardware functions can be implemented.

According to an embodiment as shown in Fig. 2, the slave processor subsystem is a program RAM based application accelerator. The slave core's programming will reside in the flash memory of the master processor. At some time following system start-up, the master processor under user control transfers the slave's programming image from the flash memory to slave's program RAM. Once the initialization of the slave is completed, the master enables the slave. The slave code is executed by the slave processor and its first task is to initialize its peripherals. Once the master and slave processors are operating, they may pass information, commands, and status to each other through the MSI module 107. The MSI module 107 provides a number of registers (mail boxes) by which information can be shared between the processors. Associated with the MSI registers is interrupt logic that are used as semaphores (flags) to gain the attention of the other processor when information is ready for transfer. There are many usage models for such an asymmetric dual core architecture: Customer generated functions may include small intensive computations (filters, PID); medium sized tasks (BLDC control); or large programs (BLDC Auto tuning). The intent for slave processor core is to act as an "Application Accelerator". The user determines which small portion of the application code needs to be accelerated. In many motor control and power control applications, a very small subset (a few K bytes) of the overall application program is run so often that it consumes the bulk (maybe 80%) of the processor's time. The application accelerator aids the partitioning of the application software into two blocks: a small control loop, and the larger general application (communications, safety checks, user interfaces, etc.). Often the control software is developed by a different group of people than those that develop the general purpose and communications software. Having two processors aids the system integration of the "hard real time" control software with the larger but less time critical portions of the application. While the slave processor's program memory is RAM based, other embodiments may implement also flash memory (internal or external) for the slave processor(s). While the use of slave flash memory is costly, it can provide very high levels of security.

According to one embodiment, the master core as shown in Fig. 2 may implemented as a dsPIC processor core clocked by a 100MHz system clock. The basic architecture of such a core is well known in the art and available from the assignee of the present application, Microchip Technology Inc. The second core may also be implemented as a dsPIC processor which runs at 120MHz. The fact that the second core (slave) runs faster than the first core is based on the implementation of the program memory which is provided by a faster volatile random access memory whereas the first core runs from a non-volatile flash memory. However, other configurations are possible. While these cores each have their own peripherals, as shown in Fig. 2, certain features may be shared, such as oscillators, reset logic, brown-out reset module, voltage regulators, JTAG, etc.. Furthermore, external pins may also be shared through a respective multiplex control logic (not shown). Ownership of the pins may be configurable.

Turning now to FIG. 3, a diagram of an example breakpoint register is shown. Each core in the processing device may be associated with its own breakpoint register. The breakpoint register 200 includes a cross breakpoint enable (CBE) bit 202 and a cross breakpoint interrupt enable (CBIE) bit 204. Typically, a break-point register is provided for each breakpoint. As will be explained in greater detail below, a core will update the corresponding status register, including the cross breakpoint enable bit 202 or cross breakpoint interrupt enable bit 204 when a breakpoint is encountered to propagate the breakpoint to the respective other core. The cross breakpoint enable bit 202 is used in a simultaneous mode, in which multiple cores may be debugged simultaneously. The cross breakpoint interrupt enable bit 204 is used in a quasi-simultaneous mode, in which one core is debugged while the other runs code. In this case, an interrupt is triggered to cause the other to get debugged while the first core resumes running code.

In particular according to an embodiment, the CBE bit enables a break signal from the debug module of one processor core to be propagated to the debug module of the other processor's debug module. This allow a break condition on one processor to also break the other processor at approximately the same time. The CBIE bit, on the other hand, enables a break signal from the debug module of one processor core to be propagated to the interrupt controller of the other processor core. This allow a break condition on one processor to interrupt the other processor at approximately the same time. This feature is useful in control applications where the customer may not want to stop the other processor while it is in a control loop. A break interrupt allows for the collection of information at the time of a break event on the other processor. Respective status bits may be used to indicate that a break event request was received from the other processor.

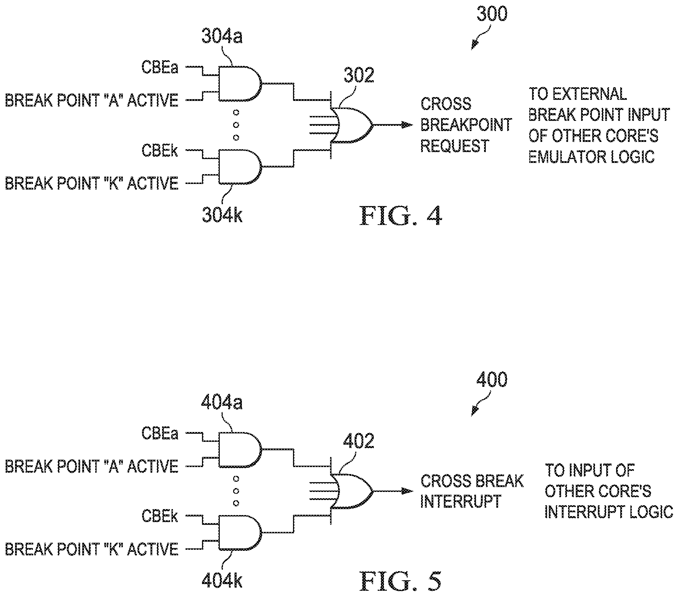

Shown in FIG. 4 shows a corresponding cross breakpoint request logic 300. Such logic may be an embodiment of logic 114, 115 of FIG. 1. The cross breakpoint enable logic may be employed in a mode allowing simultaneous debugging of multiple processors. In the embodiment illustrated, the logic includes OR gate 302 and gates 304a ... 304k. Typically, one such AND gate is provided for each breakpoint. In operation, one input to each AND gate is the corresponding breakpoint status indicator, i.e., status flag. The other input is the cross break point enable bit 202 from the breakpoint register 200 (FIG. 3) which is set when the corresponding break point is activated. Thus, in operation, when a breakpoint is active, the core sets the corresponding cross breakpoint enable bit. This causes the output of the logic 300 to assert a cross breakpoint request, which is received at a breakpoint input (not shown) of the other core's emulator logic. It is noted that other, equivalent logic may be employed.

Similarly, shown in FIG. 5 is cross breakpoint interrupt enable logic 400. Such logic may be an embodiment of logic 114, 115 of FIG. 1. Such cross breakpoint interrupt enable logic may be employed in a mode of quasi-simultaneous debugging, in which one of multiple processors is debugged while the others run application code. In the embodiment illustrated, the logic includes OR gate 402 and gates 404a - 404k. Typically, one AND gate is provided for each breakpoint. In operation, one input to each AND gate is the corresponding breakpoint status indicator, i.e., status flag. The other input is the cross break point interrupt enable bit 204 from the breakpoint register 200 (FIG. 3) which is set when the corresponding break point is activated. Thus, in operation, when a breakpoint is active, the core sets the corresponding cross breakpoint interrupt enable bit. This causes the output of the logic 400 to assert a cross breakpoint interrupt request, which is received at the input of the other core's interrupt logic 107. Again, any suitable equivalent logic may be employed.

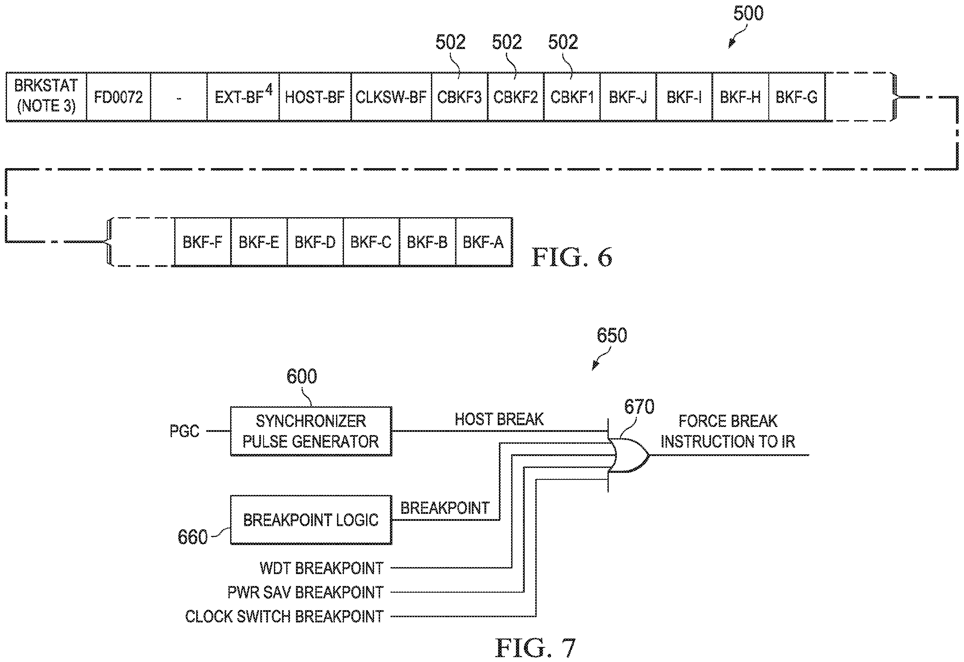

In implementing the quasi-simultaneous mode, the processing devices interrupt controller is employed to assert interrupts at the corresponding core and set the core's interrupt status register. An example interrupt status register 500 is shown in FIG. 6. Each processor core's breakpoint status register 500 includes one or more interrupt status flags corresponding to the appropriate breakpoint interrupt and is set when the interrupt request is received.

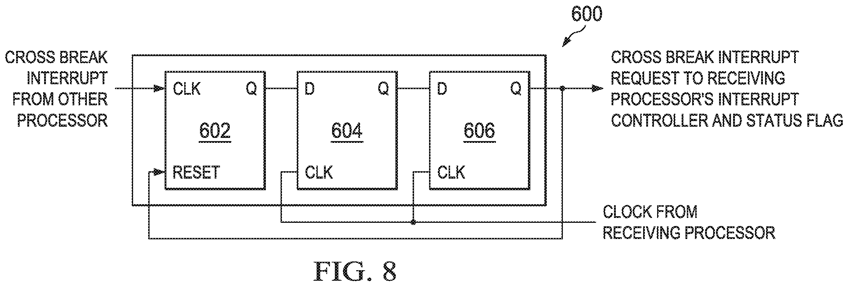

Fig. 7 shows an example of a breakpoint interface 650 for each processing core. As shown various breakpoints can be generated and combined using an OR gate 670. For example, breakpoint logic 660 may be provided to generate a user breakpoint. Other peripheral devices, such as, for example, a watchdog peripheral, a power saving function, or a clock switching unit may generate separate breakpoints. Other units generating a breakpoint upon an internal or external event may be implemented. A synchronizer pulse generator 600 is used to forward signals from the other core. Such a synchronizer pulse generator 600 can be implemented by a corresponding clock crossing circuitry for the interrupt request is shown in FIG. 8. In particular, circuitry 600 includes flipflops 602, 604, 606. Flipflops 604, 606 are clocked by the receiving processor core's clock. The clock input of the flipflop 602 is provided from the requesting processor core's cross breakpoint interrupt (i.e., the output of cross breakpoint interrupt enable logic 400). The output of the circuitry 600 is fed back to the RESET input of the flipflop 602 and is output to the receiving processor's interrupt controller 107 (FIG. 1) and used to set the interrupt status flag 502 of the status register 500.

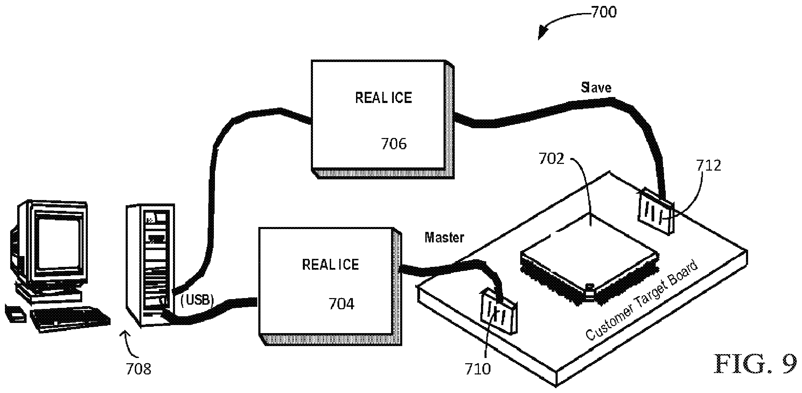

Thus, various embodiments enable the user to debug a multi-core processing device, in particular an asymmetrical multi-core processing device having two cores running at different, in particular, independent system clocks. An example debugging environment 700 that may be used in conjunction with systems and methods herein is shown in FIG. 9. As shown, the environment 700 includes a target multi-core IC device 702 on a target board 703 that includes interfaces 710, 712 for leads to corresponding in circuit emulators (ICE) 704, 706. In embodiments in which a simultaneous debugging of more than one processor is desired, an ICE is provided for each processor. Thus, in the embodiment illustrated, up to two processing cores may be simultaneously debugged. The ICEs 704, 706 may be embodied as REAL ICE emulators, manufactured and distributed by the assignee of the present application, Microchip technologies Inc., though other types are possible. Each ICE 704, 706 couples to a computer 708, such as a personal computer, laptop computer, workstation, or other device running an integrated development environment (IDE), such as the MPLABX environment also available from the assignee of the present application.

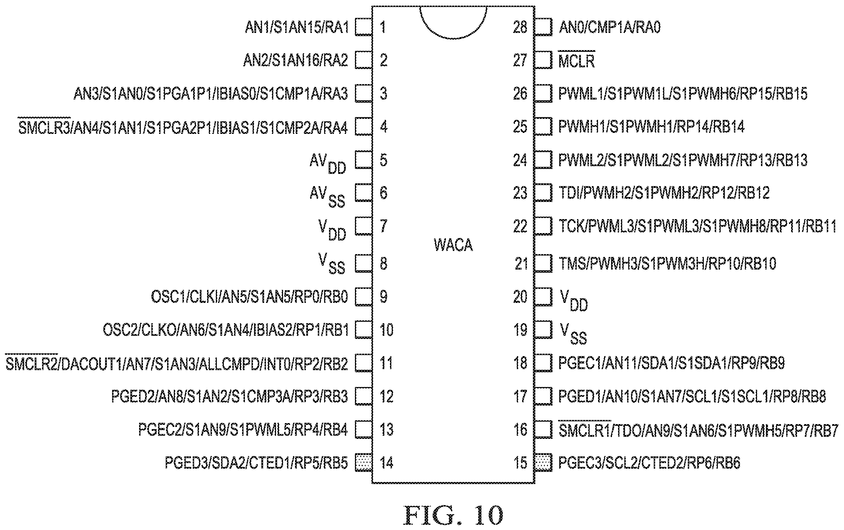

Fig. 10 shows a possible pinout in an integrated circuit device having only 28 pins and two processing cores. Three sets of external pins PGECx and PGEDx and optionally SMCLRx provide a serial programming interface for the first and/or second processing core These serial interfaces are synchronous interfaces with a separate clock and data signal lines. The emulation system provides in circuit debugger capability. The ICD capability requires the use of the customer's functional pins. Fig. 9 shows the typical ICD connections. The processor cores are in the IC 702 on the customers target board. The IC 702 must dedicate a PGCx and a PGDx pin to support the debug of one processor at a time. To support simultaneous debug of two processors, the customers board must dedicate 2 PGCx and 2 PGDx pins, plus a another pin (SMCLRx) for the slave core as the interface to the REAL ICEs as shown in Fig. 10. Both the master and slave ICDs have their own configuration bits in flash memory (BKBUG and ICS[1:0]) in the FICD and SLVICD1 registers (respectively). To select their respective pairs of PGC/D pins, and the associated SMCLRx pin for the slave. Device power on reset and brown out reset POR/BOR will reset the master and force the slave into reset state until the SLVEN bit in a control register is set again by the master. A device MCLR will reset the master but not affect the slave according to an embodiment. The slave SMCLR will force the slave into reset state until the SLVEN bit is set again by master. The master run-time resets will not affect the slave. The slave run-time resets will reset the slave but not stop it.

As noted above, in some embodiments, multiple debugging modes may be available. These may include a Master core only mode; a Slave core only mode; a Simultaneous debugging mode; and a Quasi-simultaneous debugging mode.

In the Master core only mode, debugging is similar to debugging a conventional dsPIC or PIC MCU or any other microcontroller. In such a mode, typically, a single ICE circuit emulator 704 is coupled to the target board 703 and the host computer 708 running the IDE.

In the Slave core only mode, debugging is the same as a traditional dsPIC or MCU. Again, a single ICE emulator 706 is provided and is coupled to the target board and the computer 708 running the IDE.

In the Simultaneous mode, simultaneous debugging of both the master core 102 and the slave core 104 in the multicore device 702 are implemented. The cross core breakpoints stop (break) both cores at same time, as discussed above, in response to assertion of a cross breakpoint and enable bit. The debugging environment in this case includes both ICE 704, 706 (one for each processor core) and both again are coupled to the IDE running on a host computer 708.

The Quasi-Simultaneous master and slave debug mode functions to debug one or the other of the master or slave and keep other processor running application code. In this case, the cross-core breakpoint generates interrupts to other core in response to setting the cross breakpoint interrupt enable but in the corresponding status register. The debugging environment may include one or two ICEs. For example, the processor core generating the breakpoint interrupt that is fed to the other core may be connected with an ICE 704, while the other core may not need to be connected to an ICE. Instead, the other core may be coupled with the host through a serial or parallel interface to receive information generated in a respective interrupt service routine. According to another embodiment, the other core may also be coupled with an ICE 706 that comprises a trace interface which may receive the information generated in the debug interrupt service routine.

## Claims

1. A debugging method for an integrated circuit device (100) comprising multiple processing cores (102, 104), wherein each processing core (102, 104) comprises an associated program memory and operates independently from other processing cores (102, 104), the method comprising:
activating by an emulator logic (106) at a first processor core (102,104) a debugging breakpoint at said first processor core in the integrated circuit device (100) by configuring a breakpoint register (200), wherein the debugging breakpoint stops execution of instructions in the first processor core (102); and
wherein the breakpoint register (200) comprises a bit (202) for enabling a cross breakpoint which when set causes the first processor core (102) upon occurrence of said debugging breakpoint to communicate a cross breakpoint signal to a second processor core (104) in the integrated circuit device (100) thereby stopping execution of instructions in the second processor core (104).

2. An integrated circuit device (100) comprising a plurality of processor cores (102, 104), wherein each processing core (102, 104) comprises an associated program memory and operates independently from other processing cores (102, 104), comprising:
a first processor core (102) including first emulator logic (106) for activating a first processor core breakpoint;
a breakpoint register (200) coupled with said first processor core (102) for configuring a debugging breakpoint in the first processor core (102) comprising a bit (202) for enabling a cross breakpoint;
a second processor core (104) communicatively coupled to the first processor core (102) and including second emulator logic (108); and
a first cross breakpoint logic (114) within the first emulator logic (106) which, when said bit (202) is set, is configured to communicate a cross breakpoint signal by the first emulator logic (106) at the first processor core (102) to the second processor core (104) thereby stopping execution of instructions in the second processor core (104).

3. A debugging method or integrated circuit device (100) in accordance with claim 1 or 2, wherein the breakpoint register (200) comprises a further bit (204) which when set causes upon occurrence of said debugging breakpoint at said first processor core (102) an interrupt to be asserted at an interrupt controller (122) associated with the second processor core (104).

4. A debugging method or integrated circuit device (100) in accordance with claim 3, wherein the second processor core (104) is configured to execute an interrupt service routine upon receiving said breakpoint interrupt.

5. A debugging method or integrated circuit device (100) in accordance with claim 4, wherein the interrupt service routine generates data related to the debugging breakpoint.

6. A debugging method or integrated circuit device (100) in accordance with claim 5, wherein the data is communicated to a host system (708).

7. A debugging method or integrated circuit device (100) in accordance with one of the preceding claims, wherein the first processor core (102) is clocked by a first system clock and the second processor core (104) is clocked by a second system clock which is different than the first system clock.

8. A debugging method or integrated circuit device (100) in accordance with claim 7, wherein communicating the breakpoint signal comprises synchronizing the debugging breakpoint to the second system clock.

9. A debugging method or integrated circuit device (100) in accordance with one of claims 1-8, wherein the debugging breakpoint is generated from a plurality of programmable breakpoints.

10. A debugging method or integrated circuit device (100) in accordance with claim 9, wherein said programmable breakpoints comprise instruction breakpoints and data breakpoints.

11. A debugging method or integrated circuit device (100) in accordance with one of claims 1 - 10, wherein one processor core (102) is a master core and remaining processor cores (104) are a slave cores.

12. An integrated circuit device in accordance with one of claims 1-11, wherein each emulator logic comprises an interface coupled with a set of external pins (MCLR, PGED1, PGEC1; SMCLR1, PGED2, PGEC2).

13. An integrated circuit device in accordance with one of claims 1-12, wherein a first set of peripheral devices is integrated within the integrated circuit device (100) and coupled with the first processor core (102) thereby forming a first microcontroller and a second set of peripheral devices is integrated within the integrated circuit device (100) and coupled with the second processor core (104) thereby forming a second microcontroller, wherein the first set of peripheral devices and/or the second set of peripheral devices preferably comprise a serial communication peripheral.

14. An integrated circuit device in accordance with one of claims 1-13, further comprising clock crossing circuitry (300; 400) interfacing the cross breakpoint logic (114) with the second processor core (104).

15. An integrated circuit device in accordance with claim 14, wherein the clock crossing circuitry (400) is coupled between the cross breakpoint logic (114) and an interrupt controller (122) associated with the second processor core (104).

## Patentansprüche

1. Debugging-Verfahren für eine integrierter Schaltungsvorrichtung (100), die mehrere Verarbeitungskerne (102, 104) aufweist, wobei jeder Verarbeitungskern (102, 104) einen zugeordneten Programmspeicher aufweist und unabhängig von anderen Verarbeitungskernen (102, 104) arbeitet, wobei das Verfahren aufweist:
Aktivieren, durch eine Emulatorlogik (106) an einem ersten Prozessorkern (102, 104), einen Debugging-Breakpoint an dem ersten Prozessorkern in der integrierten Schaltungsvorrichtung (100) durch Konfigurieren eines Breakpoint-Registers (200), wobei der Debugging-Breakpoint die Ausführung von Anweisungen in dem ersten Prozessorkern (102) stoppt; und
wobei das Breakpoint-Register (200) ein Bit (202) zum Aktivieren eines Cross-Breakpoints aufweist, der, wenn er gesetzt ist, bewirkt, dass der erste Prozessorkern (102) beim Auftreten des Debugging-Breakpoints ein Cross-Breakpoint-Signal an einen zweiten Prozessorkern (104) in der integrierter Schaltungsvorrichtung (100) überträgt, wodurch die Ausführung von Befehlen in dem zweiten Prozessorkern (104) gestoppt wird.

2. Integrierte Schaltungsvorrichtung (100), die eine Vielzahl von Prozessorkernen (102, 104) aufweist, wobei jeder Verarbeitungskern (102, 104) einen zugeordneten Programmspeicher aufweist und unabhängig von anderen Verarbeitungskernen (102, 104) arbeitet, die aufweist:
einen ersten Prozessorkern (102) mit einer ersten Emulatorlogik (106) zum Aktivieren eines ersten Prozessorkern-Breakpoints;
ein Breakpoint-Register (200), das mit dem ersten Prozessorkern (102) gekoppelt ist, um einen Debugging-Breakpoint in dem ersten Prozessorkern (102) zu konfigurieren, und das ein Bit (202) zum Aktivieren eines Cross-Breakpoints aufweist;
einen zweiten Prozessorkern (104), der kommunikativ mit dem ersten Prozessorkern (102) gekoppelt ist und eine zweite Emulatorlogik (108) aufweist; und
eine erste Cross-Breakpoint-Logik (114) innerhalb der ersten Emulatorlogik (106), die, wenn das Bit (202) gesetzt ist, konfiguriert ist, um ein Cross-Breakpoint-Signal durch die erste Emulatorlogik (106) am ersten Prozessorkern (102) zum zweiten Prozessorkern (104) zu übertragen, wodurch die Ausführung von Befehlen im zweiten Prozessorkern (104) gestoppt wird.

3. Debugging-Verfahren oder integrierte Schaltungsvorrichtung (100) gemäß Anspruch 1 oder 2, wobei das Breakpoint-Register (200) ein weiteres Bit (204) aufweist, das, wenn es gesetzt ist, beim Auftreten des Debugging-Breakpoints am ersten Prozessorkern (102) einen Interrupt verursacht, der an einer Interrupt-Steuerung (122) aktiviert werden soll, die dem zweiten Prozessorkern (104) zugeordnet ist.

4. Debugging-Verfahren oder integrierte Schaltungsvorrichtung (100) gemäß Anspruch 3, wobei der zweite Prozessorkern (104) ausgebildet ist, um bei Empfang des Breakpoint-Interrupts eine Interrupt-Serviceroutine auszuführen.

5. Debugging-Verfahren oder integrierte Schaltungsvorrichtung (100) gemäß Anspruch 4, wobei die Interrupt-Serviceroutine Daten erzeugt, die sich auf den Debugging-Breakpoint beziehen.

6. Debugging-Verfahren oder integrierte Schaltungsvorrichtung (100) gemäß Anspruch 5, wobei die Daten an ein Host-System (708) übertragen werden.

7. Debugging-Verfahren oder integrierte Schaltungsvorrichtung (100) gemäß einem der vorhergehenden Ansprüche, wobei der erste Prozessorkern (102) durch einen ersten Systemtakt und der zweite Prozessorkern (104) durch einen zweiten Systemtakt getaktet wird, der sich von dem ersten Systemtakt unterscheidet.

8. Debugging-Verfahren oder integrierte Schaltungsvorrichtung (100) gemäß Anspruch 7, wobei das Übertragen des Breakpoint-Signals das Synchronisieren des Debugging-Breakpoints mit dem zweiten Systemtakt aufweist.

9. Debugging-Verfahren oder integrierte Schaltungsvorrichtung (100) gemäß einem der Ansprüche 1 bis 8, wobei der Debugging-Breakpoint aus einer Vielzahl von programmierbaren Breakpoints erzeugt wird.

10. Debugging-Verfahren oder integrierte Schaltungsvorrichtung (100) gemäß Anspruch 9, wobei die programmierbaren Breakpoints Befehls-Breakpoints und Daten-Breakpoints aufweisen.

11. Debugging-Verfahren oder integrierte Schaltungsvorrichtung (100) gemäß einem der Ansprüche 1 bis 10, wobei ein Prozessorkern (102) ein Hauptkern ist und verbleibende Prozessorkerne (104) Slave-Kerne sind.

12. Integrierte Schaltungsvorrichtung gemäß einem der Ansprüche 1 bis 11, wobei jede Emulatorlogik eine Schnittstelle aufweist, die mit einem Satz externer Pins (MCLR, PGED1, PGEC1; SMCLR1, PGED2, PGEC2) gekoppelt ist.

13. Integrierte Schaltungsvorrichtung gemäß einem der Ansprüche 1 bis 12, wobei ein erster Satz von Peripherievorrichtungen in die integrierte Schaltungsvorrichtung (100) integriert und mit dem ersten Prozessorkern (102) ist gekoppelt, wodurch ein erster Mikrocontroller ausgebildet wird, und ein zweiter Satz von Peripherievorrichtungen in die integrierte Schaltungsvorrichtung (100) integriert und mit dem zweiten Prozessorkern (104) gekoppelt ist, wodurch ein zweiter Mikrocontroller ausgebildet wird, wobei der erste Satz von Peripherievorrichtungen und/oder der zweite Satz von Peripherievorrichtungen vorzugsweise eine serielle Kommunikationsperipherievorrichtung aufweisen.

14. Integrierte Schaltungsvorrichtung gemäß einem der Ansprüche 1 bis 13, die weiterhin eine Takt-Crossing-Schaltung (300; 400) aufweist, die die Cross-Breakpoint-Logik (114) mit dem zweiten Prozessorkern (104) verbindet.

15. Integrierte Schaltungsvorrichtung gemäß Anspruch 14, wobei die Takt-Crossing-Schaltung (400) zwischen der Cross-Breakpoint-Logik (114) und einer dem zweiten Prozessorkern (104) zugeordneten Interrupt-Steuerung (122) gekoppelt ist.

## Revendications

1. Procédé de débogage pour un dispositif de circuit intégré (100) comprenant de multiples cœurs de traitement (102, 104), dans lequel chaque cœur de traitement (102, 104) comprend une mémoire de programme associée et fonctionne indépendamment d'autres cœurs de traitement (102, 104), le procédé comprenant :
l'activation, par une logique d'émulation (106) au niveau d'un premier cœur de processeur (102, 104), d'un point d'arrêt de débogage au niveau dudit premier cœur de processeur dans le dispositif de circuit intégré (100) par la configuration d'un registre de point d'arrêt (200), dans lequel le point d'arrêt de débogage arrête l'exécution d'instructions dans le premier cœur de processeur (102) ; et
dans lequel le registre de point d'arrêt (200) comprend un bit (202) pour valider un point d'arrêt croisé qui, quand il est réglé, amène le premier cœur de processeur (102), lors de l'occurrence dudit point d'arrêt de débogage, à communiquer un signal de point d'arrêt croisé à un deuxième cœur de processeur (104) dans le dispositif de circuit intégré (100), arrêtant ainsi l'exécution d'instructions dans le deuxième cœur de processeur (104).

2. Dispositif de circuit intégré (100), comprenant une pluralité de cœurs de processeur (102, 104), dans lequel chaque cœur de traitement (102, 104) comprend une mémoire de programme associée et fonctionne indépendamment d'autres cœurs de traitement (102, 104), comprenant :
un premier cœur de processeur (102) incluant une première logique d'émulation (106) pour activer un premier point d'arrêt de cœur de processeur ;
un registre de point d'arrêt (200) couplé audit premier cœur de processeur (102) pour configurer un point d'arrêt de débogage dans le premier cœur de processeur (102), comprenant un bit (202) pour valider un point d'arrêt croisé ;
un deuxième cœur de processeur (104) couplé en termes de communication au premier cœur de processeur (102) et incluant une deuxième logique d'émulation (108) ; et
une première logique de point d'arrêt croisé (114) à l'intérieur de la première logique d'émulation (106) qui, quand ledit bit (202) est réglé, est configurée pour communiquer un signal de point d'arrêt croisé par la première logique d'émulation (106) au niveau du premier cœur de processeur (102) vers le deuxième cœur de processeur (104), arrêtant ainsi l'exécution d'instructions dans le deuxième cœur de processeur (104).

3. Procédé de débogage ou dispositif de circuit intégré (100) selon la revendication 1 ou 2, dans lequel le registre de point d'arrêt (200) comprend un autre bit (204) qui, quand il est réglé, amène, lors de l'occurrence dudit point d'arrêt de débogage au niveau dudit premier cœur de processeur (102), l'affirmation d'une interruption au niveau d'un dispositif de commande d'interruption (122) associé au deuxième cœur de processeur (104).

4. Procédé de débogage ou dispositif de circuit intégré (100) selon la revendication 3, dans lequel le deuxième cœur de processeur (104) est configuré pour exécuter une routine de service d'interruption lors de la réception de ladite interruption de point d'arrêt.

5. Procédé de débogage ou dispositif de circuit intégré (100) selon la revendication 4, dans lequel la routine de service d'interruption génère des données en lien avec le point d'arrêt de débogage.

6. Procédé de débogage ou dispositif de circuit intégré (100) selon la revendication 5, dans lequel les données sont communiquées à un système hôte (708).

7. Procédé de débogage ou dispositif de circuit intégré (100) selon l'une des revendications précédentes, dans lequel le premier cœur de processeur (102) est cadencé par un première horloge de système, et le deuxième cœur de processeur (104) est cadencé par une deuxième horloge de système qui est différente de la première horloge de système.

8. Procédé de débogage ou dispositif de circuit intégré (100) selon la revendication 7, dans lequel la communication du signal de point d'arrêt comprend la synchronisation du point d'arrêt de débogage avec la deuxième horloge de système.

9. Procédé de débogage ou dispositif de circuit intégré (100) selon l'une des revendications 1 à 8, dans lequel le point d'arrêt de débogage est généré à partir d'une pluralité de points d'arrêt programmables.

10. Procédé de débogage ou dispositif de circuit intégré (100) selon la revendication 9, dans lequel lesdits points d'arrêt programmables comprennent des points d'arrêt d'instructions et des points d'arrêt de données.

11. Procédé de débogage ou dispositif de circuit intégré (100) selon l'une des revendications 1 à 10, dans lequel un cœur de processeur (102) est un cœur maître et les cœurs de processeur (104) restants sont des cœurs esclaves.

12. Dispositif de circuit intégré (100) selon l'une des revendications 1 à 11, dans lequel chaque logique d'émulation comprend une interface couplée à un ensemble de broches externes (MCLR, PGED1, PGEC1 ; SMCLR1, PGED2, PGEC2).

13. Dispositif de circuit intégré selon l'une des revendications 1 à 12, dans lequel un premier ensemble de dispositifs périphériques est intégré à l'intérieur du dispositif de circuit intégré (100) et couplé au premier cœur de processeur (102), formant ainsi un premier microcontrôleur, et un deuxième ensemble de dispositifs périphériques est intégré à l'intérieur du dispositif de circuit intégré (100) et couplé au deuxième cœur de processeur (104), formant ainsi un deuxième microcontrôleur, dans lequel le premier ensemble de dispositifs périphériques et/ou le deuxième ensemble de dispositifs périphériques comprennent de préférence un périphérique de communication série.

14. Dispositif de circuit intégré selon l'une des revendications 1 à 13, comprenant également un circuit de croisement d'horloges (300 ; 400) interfaçant la logique de point d'arrêt croisé (114) avec le deuxième cœur de processeur (104).

15. Dispositif de circuit intégré selon la revendication 14, dans lequel le circuit de croisement d'horloges (400) est couplé entre la logique de point d'arrêt croisé (114) et un dispositif de commande d'interruption (122) associé au deuxième cœur de processeur (104).
